# EUROPEAN PATENT APPLICATION

(11) **EP 4 535 429 A1**
(43) Date of publication of application: **09.04.2025**
(21) Application number: 24164396.4
(22) Date of filing: 19.03.2024
(51) Int. Cl.: H01L 29/778, H01L 29/40, H01L 29/51, H01L 29/10

(54) **HIGH-ELECTRON-MOBILITY TRANSISTOR**

(30) Priority: 04.10.2023 US 202318376668
(71) Applicant: GlobalFoundries U.S. Inc., Malta, NY 12020 (US)
(72) Inventor: LEVY, Mark D., Essex Junction, VT, 05452 (US); KANTAROVSKY, Johnatan A., Essex Junction, VT, 05452 (US); ZIERAK, Michael J., Essex Junction, VT, 05452 (US); SHARMA, Santosh, Austin, TX, 78732 (US); BENTLEY, Steven J., Malta, NY, 12020 (US)
(74) Representative: Lambacher, Michael

(57) **Abstract**

The present disclosure relates to semiconductor structures and, more particularly, to a high-electron-mobility transistor and methods of manufacture. The structure includes: a semiconductor substrate; at least one insulator film over the semiconductor substrate, the at least one insulator film including a recess; and a field plate extending into the at least one recess and over the at least one insulator film.

## Description

### BACKGROUND

This invention was made with government support under Contract #HQ0727790700 awarded by Defense Microelectronics Activity (DMEA). The government has certain rights in the invention.

The present disclosure relates to semiconductor structures and, more particularly, to a high-electron-mobility transistor and methods of manufacture.

A high-electron-mobility transistor (HEMT) is a field-effect transistor incorporating a junction between two materials with different band gaps as the channel instead of a doped region (as is generally the case for a MOSFET). A commonly used material combination is GaAs with AlGaAs, although there are other material variations dependent on the application of the device. HEMTs incorporating gallium nitride, for example, provide high-power performance.

HEMTs are able to operate at higher frequencies than ordinary transistors, up to millimeter wave frequencies. Accordingly, HEMTs are used in high-frequency products such as cell phones, satellite receivers, voltage converters, and radar equipment. The HEMT can also be used in low power applications such as low power amplifiers. HEMTs, though, can exhibit high gate to drain capacitance (Cgd), which can change with application of different voltages.

### SUMMARY

In an aspect of the disclosure, a structure comprises: a semiconductor substrate; at least one insulator film over the semiconductor substrate, the at least one insulator film including a recess; and a field plate extending into the at least one recess and over the at least one insulator film.
Additional features of the structure are set forth in dependent claims 2 to 8.

In an aspect of the disclosure, a structure comprises a high electron mobility transistor comprising a semiconductor substrate, at least one insulator film over the semiconductor substrate and a field plate comprising an insulator material extending into the at least one insulator film and a metal plate over the at least one insulator film and the insulator material. Additional features of the structure are set forth in dependent claims 10 to 14.

In an aspect of the disclosure, a method comprises: forming a semiconductor substrate; forming at least one insulator film over the semiconductor substrate, the at least one insulator film including a recess exposing the semiconductor substrate; and forming a field plate extending into the at least one recess and over the at least one insulator film.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a device with a field plate, amongst other features, in accordance with aspects of the present disclosure.
FIG. 2 shows a depletion mode device with a field plate, amongst other features, in accordance with additional aspects of the present disclosure.
FIG. 3 shows a depletion mode device with a field plate, amongst other features, in accordance with additional aspects of the present disclosure.
FIG. 4 shows fabrication processes of manufacturing the devices in accordance with aspects of the present disclosure.

### DETAILED DESCRIPTION

The present disclosure relates to semiconductor structures and, more particularly, to a high-electron-mobility transistor (HEMT) and methods of manufacture. More specifically, the HEMT includes a field plate placed close to the surface of a channel region of the device, e.g., AlGaN/GaN layer. Advantageously, the HEMT described herein exhibits improved off-state leakage, in addition to providing improved switching response of the device, e.g., for both an enhancement mode GaN device and depletion mode GaN device.

In more specific embodiments, the HEMT may be a high voltage GaN device. The HEMT includes a field plate placed close to the surface of a channel region (e.g., two materials with different band gaps such as AlGaN/GaN). A thin, discrete dielectric material is deposited coincidently with and under the field plate metal to prevent or reduce leakage current. The field plate may be provided on opposing sides of a gate metal (e.g., surrounding the gate metal contact). The field plate may be separated from the gate metal contact by a sidewall spacer, with the field plate also overlapping the pGaN gate device. An insulating material over the semiconductor material (AlGaN/GaN) may be recessed, which allows the metal layer to be placed close to the semiconductor substrate, e.g., channel region. The insulating layer may be AlyOx (Al₂O₃), as an example.

The HEMT of the present disclosure can be manufactured in a number of ways using a number of different tools. In general, though, the methodologies and tools are used to form structures with dimensions in the micrometer and nanometer scale. The methodologies, i.e., technologies, employed to manufacture the HEMT of the present disclosure have been adopted from integrated circuit (IC) technology. For example, the structures are built on wafers and are realized in films of material patterned by photolithographic processes on the top of a wafer. In particular, the fabrication of the HEMT uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

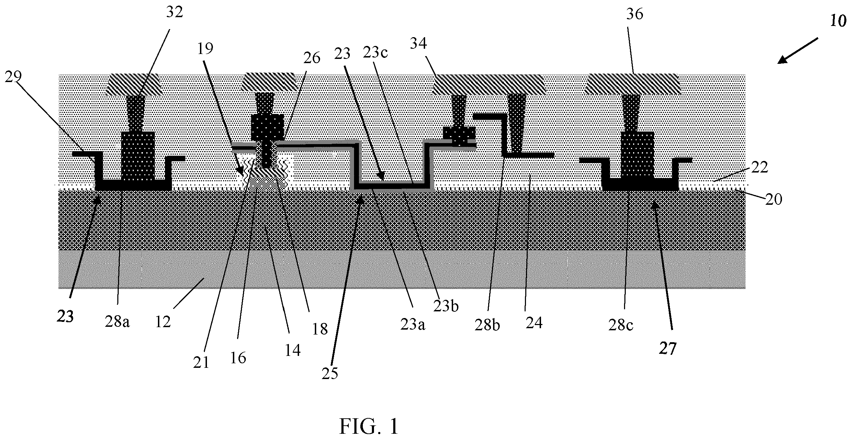

FIG. 1 shows a HEMT and respective fabrication processes in accordance with aspects of the present disclosure. More specifically, the structure 10 of FIG. 1 includes a semiconductor substrate 12 with a semiconductor material 14 on the semiconductor substrate 12. The semiconductor material 14 may be two materials with different band gaps, i.e., AlGaN/GaN, which may act as a conducting channel (active region) for the HEMT device, e.g., gate structure 19. The semiconductor substrate 12 may be composed of any suitable material including, but not limited to, Si, SiGe, SiGeC, SiC, GaAs, InAs, InP, and other III/V or II/VI compound semiconductors. In preferred embodiments, the semiconductor substrate 12 comprises p-type Si material with a suitable crystal orientation, e.g., (111).

A semiconductor material 16 and conductive material 18 may be formed, e.g., deposited and patterned, on the semiconductor material 14 to form a gate structure 19. In embodiments, the semiconductor material 16 comprises, e.g., p-doped GaN, and the conductive material 18 may be, e.g., TiN. The semiconductor material 16 may be epitaxially grown on the semiconductor material 14 with an in-situ doping, e.g., p-type doping, as is known in the art. The conductive material 18 may be deposited by a conventional deposition method (e.g., chemical vapor deposition (CVD)), followed by conventional lithography and etching processes for both materials 16, 18 to pattern the gate structure 19. In embodiments, the conductive material 18 may be pulled back slightly.

Still referring to FIG. 1, insulator materials (passivation layers) 20, 22 may be formed over the gate structure 19 and the semiconductor material 14. The insulator materials 20, 22 may be, e.g., SiO₂, AlyOx (e.g., Al₂O₃), SiN or combinations thereof. The insulator materials 20, 22 may be deposited by conventional deposition methods over the gate structure 19 and semiconductor material 14. A recess or opening 25 may be formed in the insulator materials 20, 22 to expose the underlying semiconductor material 14. The recess 25 may be formed by a conventional lithography and etching process as described herein.

A field plate 23 may be formed within the recess 25 and over the insulator material 22. In specific embodiments, the field plate 23 may comprise a metal layer 23a formed over an insulator layer 23b (e.g., thin, discrete dielectric material deposited after recess etch and patterned coincidently with the field plate metal 23a). As shown in FIG. 1, the insulator layer 23b forms sidewalls on the metal layer 23a, with the insulator layer 23b being in direct contact with the semiconductor material 14, e.g., close to the surface of a channel region of the device. The metal layer 23a may be TiN; although other metal materials are also contemplated herein. The insulator layer 23 may be a same material as the insulator material 20, e.g., AlyOx (Al₂O₃), although other insulator materials are also contemplated herein. The optional insulator layer 23c may be nitride; although other insulator materials are also contemplated herein.

The field plate 23 and, more particularly, the metal layer 23a and the insulator layer 23b within the recess 25 allows the field plate to be closer to the channel region, e.g., semiconductor material 14, of the gate structure 19. In embodiments, the insulator layer 23b will reduce corner leakage of the gate channel. The insulator layer 23b may be less than 20 nm in thickness and, preferably, less than 10 nm in thickness; although other dimensions are contemplated herein depending on the voltage technology.

The field plate 23 may be a common field plate for the gate structure 19, a source region 23 and a drain region 27. The field plate 23 may be provided in a stepped configuration with a portion close to the semiconductor material 14 within either the source region 23 or the drain region 27. In embodiments, the field plate 23 may physically contact (e.g., abut) an ohmic metal 29 of the source region 23 and the drain region 27. The ohmic metal 29 electrically contacts (and may be in physical contact) to the semiconductor material 14 (e.g., conducting channel region). It should be understood by those of skill in the art that the ohmic metal 29 may be other shapes including, for example, a via contact that extends to the semiconductor material 14.

In further embodiments, the field plate 23 may surround the ohmic metal 29 of the source region 23 and the drain region 27, as well as surround a gate contact metal 26. In this way, the field plate 23 will reduce the peak field (e.g., field crowding) at the edge of the drain region 27. In addition, the field plate 23 can provide a uniform field distribution, reduce resistance impact and provide improved device performance.

The field plate 23 may also be separated (e.g., electrically isolated) from the gate metal 26 by sidewall spacers 21 formed on sidewalls of the gate contact metal 26. The gate contact metal 26 electrically connects (contacts) to the gate structure 19 and, more specifically, contacts the conductive material 18. That is, the gate contact metal 26 may be formed in physical contact with the conductive material 18, e.g., TiN, of the gate structure 19. The field plate 23 may be electrically isolated and physically separated from the gate structure 19 and, more specifically, the gate contact metal 26, by the sidewall spacers 21.

An interlevel dielectric material 24, e.g., layers of oxide and/or nitride, may be formed under and over the field plate 23 (and partially under the field plate 23). The gate contact metal 26 may be, e.g., TiAl or TiN, formed by patterning of the interlevel dielectric material 24 to form a trench and which exposes the conductive material 18, e.g., TiN, followed by deposition of conductive material, e.g., TiAl or TiN. In embodiments, the gate contact metal 26 and the ohmic metal 29 may be the same metal materials formed in similar processes, e.g., conventional CMOS processes. Prior to forming the gate contact metal 26, sidewall spacers 21 (e.g., nitride and/or oxide material) may be blanket deposited (e.g., lined) in the trench by a conventional deposition process, e.g., CVD, followed by a conventional etching process.

Still referring to FIG. 1, ohmic contacts 28a, 28c may contact (e.g., electrically connect) to the underlying semiconductor material 14 (e.g., conducting channel) by way of the ohmic contacts 27. It should be understood by those of skill in the art that the ohmic contacts 27 may be eliminated and that the ohmic contacts 28a, 28c may directly connect to the source region 23 and drain region 27 (e.g., semiconductor material 14). The ohmic contact 28b may contact the gate contact metal 26.

Additional interlevel dielectric material 24 may be formed over the interlevel dielectric material 24. Back end of the line contacts (e.g., metal vias) 32 may connect to the ohmic contacts 28a, 28c. The back end of the line contacts 32 may also contact the field plate 23 through the gate contact metal 26. The ohmic contacts 28a, 28c may comprise, e.g., TiAl or TiN. Metal wiring 34, 36 connect to the source region 23 and the drain region 27, respectively. In embodiments, the metal wiring 34, 36 may electrically connect and be in direct contact with the via contacts 32 for the source region 23 and the drain region 27.

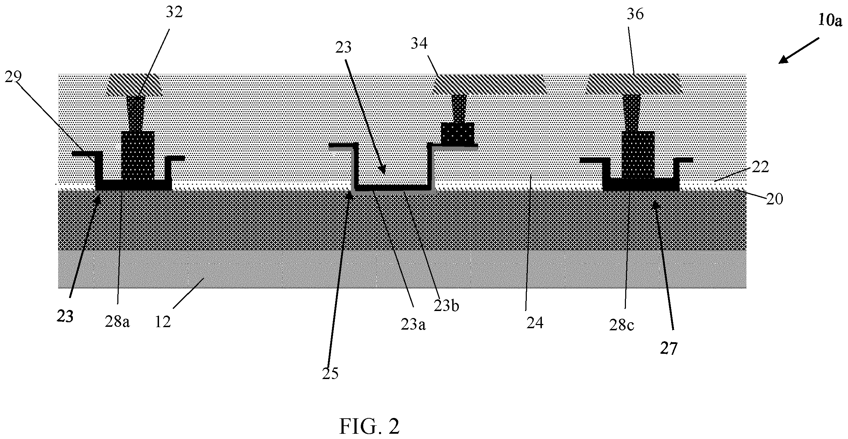

FIG. 2 shows a depletion mode device (D-mode) with a field plate, amongst other features, in accordance with additional aspects of the present disclosure. More specifically, the depletion mode device 10a includes the field plate 23 within the recess 25. As this is a D-mode device, the gate structure is no longer required as the field plate 23 will act as the gate structure. As in each of the embodiments, the insulator material 23b will be coincident with the metal material 23a and may be the same or different material than the insulator material 20. In this structure, the insulator material 23b will again be in contact with the semiconductor substrate 14. The optional insulator material 23c may also be eliminated; although, this optional insulator material may also be present. In this structure, the D-mode Vpinch modulation (e.g., D-mode transistor pinch-off voltage) has been shown to be improved. The remaining structures are the same or similar to that of the structure 10 of FIG. 1.

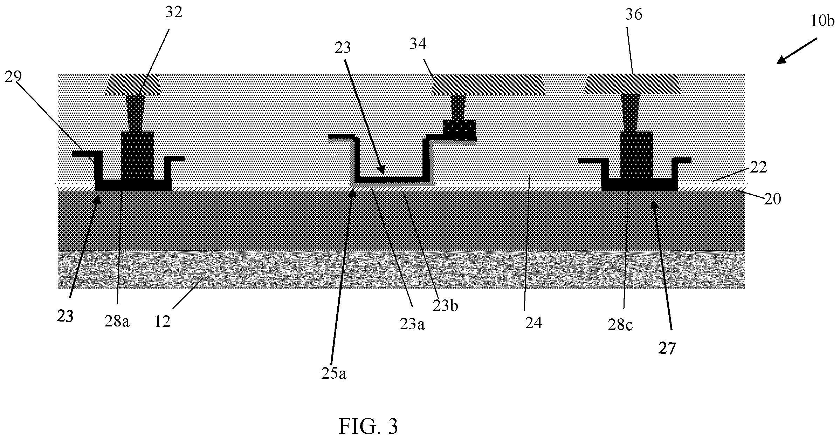

FIG. 3 shows a depletion mode device (D-mode) with a field plate, amongst other features, in accordance with additional aspects of the present disclosure. More specifically, the depletion mode device 10b includes the field plate 23 within a recess 25a formed only in the upper insulator layer 22. As this is a D-mode device, the gate structure is no longer required as the field plate 23 will act as the gate structure. As in each of the embodiments, the insulator material 23b will be coincident with the metal material 23a and may be the same or different material than the insulator material 20. In this structure, the insulator material 23b will be in contact with the insulator material 20. The optional insulator material 23c may also be eliminated; although, this optional insulator material may also be present. In this structure, the D-mode Vpinch modulation has been shown to be improved. The remaining structures are the same or similar to that of the structure 10 of FIG. 1 or FIG. 2.

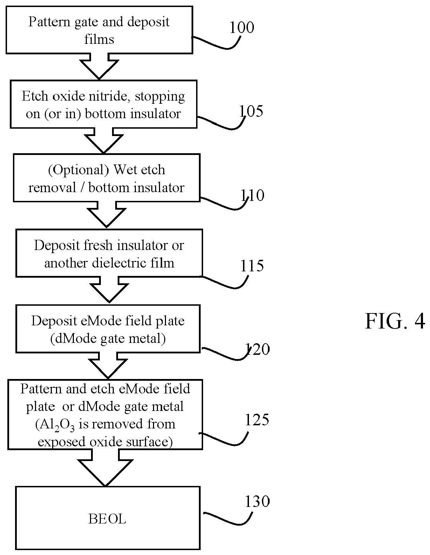

FIG. 4 shows a flow representing fabrication processes of manufacturing the devices in accordance with aspects of the present disclosure. The fabrication processes may be used for both an E-mode device and a D-mode as noted throughout the description of the flow. Specifically, in the E-mode device, the gate structure is patterned by conventional deposition, lithography and etching processes as is known in the art; wherein in the D-mode device, the gate structure will be eliminated.

For example, at step 100, semiconductor material 16 and conductive material 18 may be deposited and patterned on the semiconductor material 14 to form the gate structure 19. In embodiments, the semiconductor material 16 comprises, e.g., p-doped GaN, and the conductive material 18 may be, e.g., TiN. The semiconductor material 16 may be epitaxially grown on the semiconductor material 14 with an in-situ doping, e.g., p-type doping, as is known in the art. The conductive material 18 may be deposited by a conventional deposition method (e.g., CVD), followed by conventional lithography and etching processes for both materials 16, 18 in order to pattern the gate structure 19. Materials 20, 22 are deposited on the gate structure 19 and over the semiconductor material 14. Interlevel dielectric material may also be formed, e.g., deposited by a known CVD process, over the material 22.

At steps 105 and 110, a field plate recess is patterned to expose the underlying semiconductor material 14. For example, at step 105, an oxide and nitride etch are performed to remove portions of the interlevel dielectric material 24 and material 22. This etch will stop on or slightly within the example, material 20. At step 110, an optional wet etch may be performed to remove material 20, e.g., Al₂O₃, to expose the underlying semiconductor material 14.

At step 115, a dielectric material can be deposited within the recess over the semiconductor material 14. For example, Al₂O₃ may be deposited on the underlying semiconductor material 14.

Thereafter, at step 120, the material for the field plate 23 can be deposited over interlevel dielectric material 24 and within the recess 25. The field plate 23 may be used as the gate structure in the D-mode device. In any embodiment, the field plate 23 may include a metal layer 23a formed over an insulator layer 23b (e.g., thin, discrete dielectric material), which is deposited after the recess etch and patterned coincidently with the field plate metal 23a. An optional insulator layer 23c may be formed over the metal layer 23a, which is also patterned coincidently with the field plate metal 23a. herein. The optional insulator layer 23c may be nitride; although other insulator materials are also contemplated herein.

At step 125, the field plate 23 can be patterned using conventional lithography and etching processes. The patterning may include all of the layers 23a, 23b, 23c. In embodiments, any Al₂O₃ may be removed from underlying oxide material.

At step 130, the back end of line processes are performed as is known in the art. For example, additional interlevel dielectric material 24 may be deposited over the gate structure 19 and field plate 23. Trenches may be formed in the dielectric material, exposing the conductive material 18 of the gate structure 19, in addition to exposing the semiconductor material 14 in the source region 23 and the drain region 27. The trenches may be formed through portions of the field plate 23.

The trenches may be formed by conventional lithography and etching methods known to those of skill in the art. For example, a resist formed over the dielectric material 24 is exposed to energy (light) and developed utilizing a conventional resist developer to form a pattern (opening). An etching process with a selective chemistry, e.g., reactive ion etching (RIE), will be used to transfer the pattern into the interlevel dielectric material 24.

The ohmic contacts may also be formed in the trenches, in contact with the semiconductor material 14 in the source region 23 and the drain region 27 and the gate structure 19. In embodiments, the gate metal contact and the ohmic contacts may be formed in the same deposition process, followed by a CMP process to remove any excessive conductive material on the dielectric material 24. Sidewall spacers may also be formed on sidewalls of the gate contract in order to isolate the gate contact from the field plate 23.

The back end of the line contacts 32 and the ohmic contacts may be formed using conventional lithography, etching and deposition processes as is known in the art. The ohmic contacts may comprise, e.g., TiAl or TiN. The metal wirings 34, 36 to the source region 23 and the drain region 27 may be formed by back end of the line metal processes (e.g., TiN liner with tungsten fill) as is known in the art such that no further explanation is required for a complete understanding of the present disclosure.

The HEMT can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multi-chip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a semiconductor substrate;
at least one insulator film over the semiconductor substrate, the at least one insulator film including a recess; and
a field plate extending into the at least one recess and over the at least one insulator film.

2. The structure of claim 1, wherein the field plate is a gate structure for a D-mode device.

3. The structure of claim 1 or claim 2, wherein the field plate includes an insulator material within the recess and in contact with the semiconductor substrate, and a metal layer over the insulator material, and, optionally, wherein the insulator material forms a sidewall on vertical portions of the metal layer of the field plate.

4. The structure of claim 3, wherein the insulator material and the at least one insulator film comprise a same material, and, optionally wherein the insulator material and the at least one insulator film comprise AlyOx.

5. The structure of one of claims 1 to 4, wherein the field plate comprises an insulator film under and over a metal layer.

6. The structure of one of claims 1 to 5, wherein the at least one insulator film comprises two insulator films, and the recess extends into the two insulator films to expose the semiconductor substrate, or wherein the at least one insulator film comprises two insulator films, and the recess extends into a top of the two insulator films to expose a bottom of the two insulator films.

7. The structure of one of claims 1 to 6, further comprising a gate structure on the semiconductor substrate for an E-mode device, and, optionally, wherein the gate structure comprises pGaN material.

8. The structure of one of claims 1 to 7, wherein the semiconductor substrate comprises AlGaN/GaN material.

9. A structure comprising a high electron mobility transistor comprising a semiconductor substrate, at least one insulator film over the semiconductor substrate and a field plate comprising an insulator material extending into the at least one insulator film and a metal plate over the at least one insulator film and the insulator material.

10. The structure of claim 9, further comprising a gate structure comprises pGaN material, and wherein the semiconductor substrate includes a source region and a drain region comprising AlGaN/GaN material.

11. The structure of claim 9 or claim 10, wherein the field plate is a gate structure for a D-mode device.

12. The structure of one of claims 9 to 11, wherein the insulator material of the field plate extends within a recess of the least one insulator film and which contacts the semiconductor substrate, and/or wherein the insulator material and the at least one insulator film comprise AlyOx.

13. The structure of claim 12, wherein the at least one insulator film comprises two insulator films, and the recess extends into the two insulator films.

14. The structure of one of claims 9 to 13, wherein the at least one insulator film comprises two insulator films, with a recess within into a top of the two insulator films and the insulator material of the field plate extends to within the recess and contacts a bottom insulator film of the two insulator films.

15. A method comprising:
forming at least one insulator film over semiconductor substrate, the at least one insulator film including a recess exposing the semiconductor substrate; and
forming a field plate extending into the at least one recess and over the at least one insulator film.
